# DEMANDE DE BREVET EUROPEEN

(11) **EP 3 819 695 A1**
(43) Date de publication de la demande: **12.05.2021**
(21) Numéro de dépôt: 20205591.9
(22) Date de dépôt: 04.11.2020
(51) Int. Cl.: G02B 26/08, G02B 26/10, H03H 9/02, H03H 9/24

(54) **RÉSONATEUR ÉLECTROMÉCANIQUE PRÉSENTANT DES MODES DE RÉSONANCE SECONDAIRES DÉCALÉS**

(30) Priorité: 05.11.2019 FR 1912380
(71) Demandeur: Tu-Yang, 13453 Marseille Cedex 13 (FR)
(72) Inventeur: BISSI, Piero, 13530 TRETS (FR)
(74) Mandataire: LLR

(57) **Abrégé**

Résonateur électromécanique (1) comprenant une lame de torsion (2) s'étendant selon un axe longitudinal (XX') et fixée par ses deux extrémités sur un cadre (3). La lame de torsion comportant un ou plusieurs bras, s'étendant depuis une partie centrale de la lame de torsion à l'extrémité desquels sont disposés des aimants (7) placés chacun au droit d'une bobine électromagnétique (6) montée sur le cadre (3), de sorte que la lame de torsion oscille autour de l'axe longitudinal (XX'). Le cadre comporte une tige de pré-tension (4) pour soumettre la lame de torsion à une contrainte de traction. La lame de torsion est formée d'un matériau dont la contrainte de rupture est supérieure ou égale à 1200 MPa et préférentiellement supérieure à 2000MPa, et la tige de pré-tension soumet la lame de torsion à une contrainte de traction comprise entre 800 MPa et ladite contrainte de rupture de la lame de torsion.

## Description

L'invention concerne le domaine des éléments électromécaniques, généralement de petite taille, comportant un miroir oscillant à une fréquence déterminée correspondant à la fréquence de résonance d'une lame de torsion.

Ces dispositifs, encore dénommés résonateurs optiques et utilisés pour contrôler un faisceau de lumière ou d'énergie radiante, sont par exemple couramment employés dans l'industrie pour équiper des lecteurs optiques tels que des scanners.

On connaît déjà dans l'état la technique, notamment d'après le document US 3 532 408, un résonateur formé d'une lame de torsion suspendue par ses deux extrémités sur un cadre soumettant ladite lame de torsion à une tension ajustable. La lame de torsion comprend des bras s'étendant en croix vers l'extérieur depuis le centre de la lame de torsion. Des aimants sont disposés aux extrémités de chacun des bras.

Un miroir est monté directement, ou par l'intermédiaire d'une entretoise, au centre de la lame de torsion. De manière alternative, le centre de la lame de torsion est poli pour réfléchir la lumière.

La fréquence propre d'oscillation de la lame de torsion autour de son axe principal est déterminée par l'élasticité de la lame et par le moment d'inertie des aimants, de l'entretoise, de la partie mobile de la lame et du miroir.

On entend ici par axe principal, l'axe XX' reliant les deux extrémités de la lame de torsion. L'axe YY' représente l'axe passant par les deux bras, et l'axe ZZ' représente un axe vertical, perpendiculaire aux deux axes précédents.

Une bobine excitatrice disposée sur le cadre en vis-à-vis d'un aimant, met la lame en vibration et une bobine réceptrice, disposée en vis-à-vis de l'autre aimant, produit un courant électrique, de même fréquence, qui est amplifié pour alimenter à son tour la bobine excitatrice. La lame de torsion oscille alors autour de son axe principal de manière extrêmement stable à la fréquence de résonance mécanique de l'ensemble formé de la lame de torsion et des masses oscillantes.

Le plan du miroir, perpendiculaire à l'axe ZZ' oscille également à la même fréquence autour de cet axe longitudinal. Le miroir peut alors utilement servir pour dévier un faisceau lumineux à une fréquence de balayage stable, prédéterminée et peu sensible aux mouvements externes.

La fréquence principale de résonnance se situe généralement entre quelques dizaines de hertz et 2000Hz.Toutefois, ce type de montage, mettant en œuvre les propriétés mécaniques des masses en mouvement, reste sensible aux effets de vibrations parasites autour ou le long des axes YY' et ZZ'. Ces vibrations parasites peuvent elles-mêmes entrer en résonance à des fréquences de résonance dites secondaires qui peuvent être proches de la fréquence de résonance du mode principal et qui sont alors susceptibles de perturber la stabilité de fonctionnement du résonateur.

Les concepteurs de ces résonateurs mécaniques cherchent donc à annuler les effets de ces fréquences de résonance dites secondaires.

Le document US 4 732 440 propose, pour résoudre ce problème, de supprimer le ressort de torsion et de fixer le miroir directement sur des ressorts en forme de S placés en opposition verticalement (axe ZZ') entre le miroir et la base. Cette structure plus rigide réduit les modes propres secondaires. Cette solution reste néanmoins difficile et donc coûteuse à mettre en œuvre dans le cas de dispositif dont la taille n'excède pas quelques millimètres.

Une autre proposition technique ayant pour objet de résoudre ce problème est décrite dans le document US 5 550 669 qui suggère d'installer un ressort de torsion vertical reliant la base au miroir. Cette solution est également complexe à mettre en œuvre dans un dispositif de taille millimétrique.

Le document US 8 654 423 propose de fixer le miroir sur la lame de torsion de telle sorte que le plan du miroir soit perpendiculaire à l'axe transversal YY'. Ce dispositif nécessite alors l'usage d'un support monté entre les deux extrémités de la lame de torsion pour fixer le miroir.

Le document US 7 327 772 s'intéresse aux résonateurs utilisés en particulier dans les chambres d'amplification laser et propose de modifier la forme du miroir de manière à rendre instables les fréquences de résonance secondaires. Mais cette solution n'est pas transposable aux dispositifs mécaniques plus traditionnels comprenant une lame de torsion.

L'invention a pour objet de proposer une solution alternative moins onéreuse que les solutions énoncées ci-dessus et plus particulièrement adaptée à des résonateurs électromécaniques de faible dimension comprenant une lame de torsion. A cet effet, l'invention a pour objet un résonateur électromécanique comprenant une lame de torsion s'étendant selon un axe longitudinal (XX') et fixée par ses deux extrémités sur un cadre. La lame de torsion comporte un ou plusieurs bras, s'étendant depuis une partie centrale de la lame de torsion selon un axe transversal (YY'), à l'extrémité desquels sont disposés des aimants placés chacun au droit d'une bobine électromagnétique montée sur le cadre, de sorte que, lorsque le résonateur est en fonctionnement, la lame de torsion oscille autour de l'axe longitudinal. Ledit cadre comporte une tige de pré-tension pour soumettre une partie libre de la lame de torsion à une contrainte de traction.

Ce résonateur se caractérise en ce que la lame de torsion est formée d'un matériau dont la contrainte de rupture est supérieure ou égale à 1200 MPa et préférentiellement supérieure à 2000 MPa, et que la tige de pré-tension soumet la partie libre de la lame de torsion à une contrainte de traction comprise entre 800 MPa et ladite contrainte de rupture de la lame de torsion.

On entend ici par contrainte de traction la contrainte exercée sur la partie libre de la lame de torsion, au niveau de la section de plus faible largeur de ladite partie libre.

De manière usuelle, et pour un moment d'inertie du système constant, la contrainte de traction de la lame de torsion des résonateurs électromécaniques couramment disponible sur le marché est de l'ordre de 100 ou 200 MPa et peut être ajustée autour de ces valeurs d'une centaine de MPa supplémentaire pour affiner la fréquence de résonance principale de 1% voire de 2%. Dans cette plage de réglage, les fréquences secondaires varient de l'ordre de 20% à 30%, ce qui peut s'avérer insuffisant. La mise en traction de la lame à des valeurs supérieures à 300 MPa s'avère généralement impossible en raison de la rupture prématurée de la lame de torsion elle-même.

L'invention se propose de vaincre ce préjugé et suggère de renforcer la résistance à la rupture de la lame de torsion de manière à autoriser des valeurs de contraintes de traction supérieures voire très supérieures aux valeurs couramment pratiquées. Cette modification substantielle de la résistance structurelle de la lame a permis de conduire des essais à des valeurs de contraintes de traction largement plus importantes, dépassant 800 MPa et pouvant s'élever à des valeurs proches de la limite de rupture de lame. Il a été mis en évidence de façon surprenante que le premier mode de résonance ne s'élevait, que de quelques pourcents au fur et à mesure de l'élévation de la contrainte de traction appliquée sur la lame de torsion, alors que les fréquences de résonance des modes secondaires d'ordre 2 et 3 évoluaient beaucoup plus fortement et pouvaient doubler voire tripler et s'éloigner ainsi de la fréquence de résonance principale, de sorte que ces fréquences de résonance secondaires ne peuvent plus constituer une perturbation dans le fonctionnement du résonateur. Bien évidemment, cette force de traction doit rester inférieure à la force de rupture de la lame de torsion qui est alors supérieure ou égale à 1200 Mpa et préférentiellement supérieure ou égale à 2000 MPa.

Le résonateur électromécanique selon l'invention comprend également les caractéristiques optionnelles suivantes prises seules ou en combinaison :
- Le cadre comporte un socle supportant deux montants transversaux sur lesquels sont fixées les deux extrémités de la lame de torsion.
- La tige de pré-tension est disposée longitudinalement entre les deux montants de sorte que la mise en compression de la tige de pré-tension entraîne la mise en traction de la lame de torsion.
- La mise en compression de ladite tige de pré-tension est ajustable à l'aide d'une vis de réglage.
- Un miroir, monté par l'intermédiaire d'au moins une entretoise sur la partie centrale de la lame de torsion ou réalisé par polissage de la partie centrale de ladite lame de torsion, s'étend dans un plan formé par les axes longitudinaux et transversaux.
- Les extrémités de la lame de torsion s'étendent transversalement de part et d'autre de l'axe longitudinal et sont fixées chacune sur les montants du cadre.
- Le rayon de raccordement entre la partie libre de la lame de torsion et un bras ou une zone d'attache de la lame de torsion est constant et supérieur en tous points à une largeur minimale de la lame de torsion.
- Dans un secteur angulaire de 45° adjacent à la partie libre de la lame de torsion, le rayon de raccordement entre la partie libre de la lame de torsion et un bras ou une zone d'attache est en tous points supérieur à une largeur minimale de la partie libre de la lame de torsion.
- Dans un secteur angulaire de 45° adjacent à la partie libre de la lame de torsion le rayon de raccordement entre la partie libre de la lame de torsion et un bras ou une zone d'attache, est en tous points supérieur à deux fois une largeur minimale de la partie libre de la lame de torsion.
- Dans un secteur angulaire de 45° adjacent à la partie libre de la lame de torsion le rayon de raccordement entre la partie libre de la lame de torsion et un bras ou une zone d'attache, est en tous points supérieur à trois fois une largeur minimale de la partie libre lame de torsion.
- Une dimension principale du résonateur est inférieure ou égale à 20 mm et préférablement inférieure à 10 mm.

### Brève description des figures

L'invention sera mieux comprise à la lecture de la description qui va suivre donnée uniquement à titre d'exemple et faite en se référant aux dessins annexés dans lesquels :
[Fig. 1] la figure 1 est une vue schématique en perspective d'un résonateur électromécanique selon l'invention.
[Fig. 2] la figure 2 est une vue schématique de dessus de la lame de torsion.

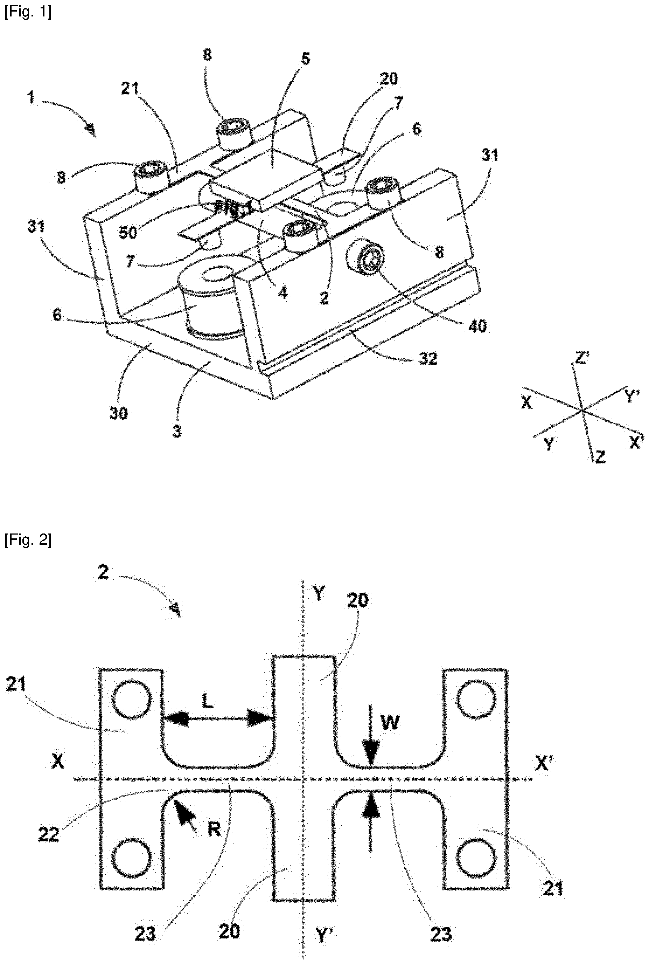

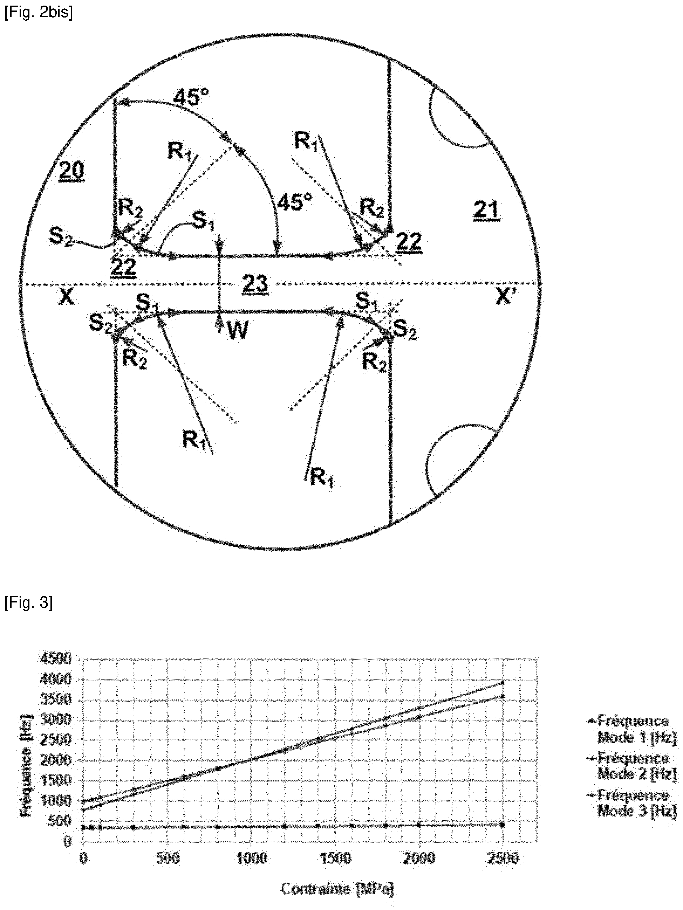

[Fig 2bis] la figure 2 bis est une vue schématique détaillée du médaillon de la figure 2 illustrant une variante de réalisation de l'invention.
[Fig. 3] la figure 3 représente, à titre d'exemple, l'évolution des fréquences de résonance principales et secondaires d'ordre deux et trois en fonction de l'évolution de la contrainte de traction.

### Description détaillée

On a représenté à la figure 1 un résonateur électromécanique 1 de type connu en soi. La figure 2 représente une vue de détail de la lame de torsion 2 proprement dite.

Ce résonateur est composé d'un cadre 3, formé d'une base 30 et de deux montants transversaux 31 disposés en vis-à-vis l'un de l'autre, perpendiculairement à un axe longitudinal XX'.

La lame de torsion 2, s'étendant selon l'axe longitudinal XX', est fixée à chacune de ses extrémités sur chacun des montants transversaux 31. Ces extrémités en forme de T constituent une zone d'attache 21. Chaque zone d'attache 21 est fixée sur le rebord d'un montant par deux vis 8.

Deux bras 20 s'étendent en croix vers l'extérieur, selon un axe transversal YY' perpendiculaire à l'axe longitudinal XX', depuis le centre de la lame de torsion 2. Des aimants 7 sont disposés à chacune des extrémités transversales des deux bras 20.

Ces aimants 7 sont disposés chacun au droit d'une bobine électromagnétique 6 disposée sur le cadre 3.

Une première bobine est une bobine excitatrice dans laquelle circule, à une fréquence régulière, un courant générateur qui attire l'aimant placé au droit de ladite bobine excitatrice et provoque de la sorte la torsion élastique de la lame de torsion 2 autour de l'axe XX'.

La bobine réceptrice placée au droit de l'aimant disposé sur le bras 20 opposé génère un courant de même fréquence. Ce courant est amplifié par un amplificateur (non représenté) et sert à son tour de courant générateur. Après quelques cycles de démarrage, la lame oscille autour de l'axe principal XX' à une fréquence correspondant à la fréquence de résonance principale de la lame autour de l'axe XX'.

On fera observer ici qu'il est également tout à fait possible, moyennant une adaptation de la commande électronique, de réaliser un dispositif ne comprenant qu'une seule bobine faisant alternativement office à chaque cycle d'oscillation de bobine émettrice et de bobine réceptrice. De la même manière, il est également possible de combiner les arrangements précédents et de réaliser un dispositif comprenant trois voire quatre bras.

La fréquence de résonance principale est remarquablement stable et la consommation électrique de l'amplificateur pour entretenir le mouvement est extrêmement faible.

Il est alors intéressant d'utiliser les propriétés du résonateur électromécanique pour régler à titre d'exemple, un mouvement d'horloge ou, plus couramment, pour servir de support à un miroir 5 oscillant, sur lequel on projette un rayon lumineux provenant d'une source fixe. Le rayon réfléchi par le miroir 5 permet de balayer l'espace linéairement dans un plan perpendiculaire à la direction longitudinale XX'. Ce type de résonateur est couramment utilisé pour des scanners de tous types.

Le miroir 5 est monté sur la partie centrale de la lame de torsion 2 par l'intermédiaire de deux entretoises 50, disposées de part et d'autre de l'axe longitudinal XX'.

La fréquence de résonance peut alors facilement se calculer en prenant en compte les paramètres géométriques du dispositif (L, W), l'élasticité de la lame, et la répartition des masses oscillantes (miroir, aimants, entretoise...)

Pour ajuster la fréquence de résonance il est prévu une tige de pré-tension 4 disposée selon l'axe longitudinal XX' entre les deux montants transversaux 31 du cadre 3. Une vis 40 permet de régler la compression de la tige de pré-tension 4 pour produire une force ayant tendance à éloigner les deux montants transversaux 31 l'un de l'autre, de sorte que la lame de torsion 2 est mise en traction. Il va de soi que tout autre moyen produisant le même résultat peut être utilisé.

Pour améliorer l'effet de la tige de pré-tension 4, une zone flexible déformable 32, se présentant sous la forme d'une gorge transversale, peut être aménagée au pied d'un des montants 31.

En référence à la figure 2, la lame de torsion comporte deux parties libres 23 disposées chacune de part et d'autre d'une partie centrale d'où s'étendent transversalement les bras 20. Cette partie libre 23, également désignée sous l'appellation anglo-saxonne de « taut band », a une longueur L et une largeur minimale W, mesurée selon la direction transversale sur la partie libre de la lame de torsion. Cette partie correspond à la partie de la lame de torsion 2 qui se tord autour de l'axe XX' lorsque le résonateur est en fonctionnement. La longueur libre totale est donc égale à deux fois la longueur L. C'est au niveau de la partie libre 23 de largeur minimale W que sont mesurées les contraintes de traction exercée sur la lame de torsion.

La lame de torsion, comprenant la zone d'attache 21, les parties libres 23 et les bras 20, a une épaisseur e constante inférieure d'un demi ordre de grandeur à la largeur W. On entend ici par un ordre de grandeur une valeur inférieure d'un facteur dix à la valeur de référence.

Pour pouvoir supporter des contraintes de traction supérieures, voire très supérieures, aux valeurs usuellement rencontrées il s'avère nécessaire de renforcer la résistance mécanique de la lame de torsion.

Une première mesure consiste donc à sélectionner un matériau, dont la force rupture est ajustée aux valeurs de traction recherchées. A titre d'exemple, un acier présentant une force rupture supérieure ou égale à 1200 MPa, permet d'atteindre les valeurs de traction pour lesquelles l'éloignement des modes de résonnance secondaires d'ordre deux et trois commence à être sensible et ne présente plus une source d'instabilité comme évoqué ci-dessus. A titre préférentiel, si l'on souhaite éloigner encore plus les modes de résonnances secondaires de la fréquence principale, on sélectionnera un acier présentant une limite de rupture supérieure.

La valeur de la contrainte de traction ne peut bien évidemment pas excéder la contrainte de rupture de la lame de torsion. On sélectionnera donc un matériau dont la contrainte de traction est supérieure à 1200 MPa et préférentiellement supérieure à 2000MPa, si l'on souhaite décaler de manière encore plus significative lesdites résonnances secondaires.

Le renforcement de la lame de torsion nécessite également d'apporter un soin particulier aux formes de la lame elle-même.

Chacune des parties libre 23 est reliée à la zone d'attache 21 ou à un bras 20 par une zone intermédiaire dite zone de raccordement 22. Selon une première configuration, on veillera à ce que le rayon de raccordement entre la partie libre 23 et la zone d'attache 21 ou le bras soit supérieur en tous points à la largeur minimale W de la partie libre 21 (R≥W). Préférentiellement le rayon R pourra utilement être supérieur à deux fois la largeur minimale W (R≥2W), et encore plus préférentiellement supérieur à trois fois ladite largeur minimale W (R≥3W). Ce rayon R peut être constant.

Alternativement, il est également possible de réaliser des raccordements à rayon variable. Dans ces conditions, pour obtenir les propriétés de résistance désirées, il convient que le rayon de raccordement situé dans un secteur angulaire S₁ donné soit supérieur à la largeur minimale de la partie libre W. Pour ce faire, et en référence à la figure 2bis, on partage la zone de raccordement 22 en deux secteurs S₁ et S₂ de 45°. Le secteur S₁ est le secteur de la partie de la zone de raccordement 23 adjacent à la partie libre 21 et le secteur S2 est le secteur adjacent au bras 20 ou à la zone d'attache 21. Il convient alors que, en tous points du secteurs S₁, adjacent à la partie libre 21, le rayon R₁ de raccordement soit supérieur à la largeur W de la partie libre 23 et préférentiellement supérieur à deux fois la largeur W (R₁>2W) et encore plus préférentiellement supérieur à trois fois la largeur minimale W R₁>3W). A titre d'exemple, la forme de la courbe géométrique de la zone de raccordement dans ce secteur S₁ peut être une portion de cercle, une portion d'ellipse, une portion de spirale ou encore une portion de clothoïde ou de spline.

La forme de la courbe de la zone de raccordement située dans le secteur S₂, adjacent au bras 20 ou à la zone d'attache 21, peut être préférentiellement de forme courbe de rayon fixe ou variable à définir, pour prolonger harmonieusement la partie de la courbe située dans le secteur S₁. Ce rayon peut être inférieur ou supérieur à W.

De même, un rayon de raccordement constant sur toute la zone de raccordement comprenant le secteur S₁ et le secteur S₂, présentera alors une valeur supérieure à W, comme cela est indiqué ci-dessus.

L'optimisation de la forme des rayons permet d'augmenter la contrainte de traction exercée sur la lame de torsion tout en conservant une bonne résistance à la torsion de la lame.

Une autre mesure, connue en soi, consiste également à modifier le rapport entre l'épaisseur et la largeur ou à améliorer l'état de surface de la lame de torsion 2 de manière à éliminer toutes les amorces de rupture susceptibles de réduire la force de traction maximale supportée par la lame de torsion 2.

Comme cela a été évoqué ci-dessus, il est possible d'ajuster la fréquence de résonance en modifiant, à l'aide de la vis de réglage 40, la contrainte de traction appliquée par la tige de pré-tension 4 à la lame de torsion 2.

La figure 3 illustre, à titre d'exemple, l'évolution de la fréquence de résonance principale et des fréquences de résonance secondaires de Mode 2 et de Mode 3 lorsque l'on fait varier de manière importante la contrainte de traction appliquée sur la lame de torsion. Ces fréquences évoluent de manière sensiblement linéaire.

Lorsque la contrainte est nulle, ou très légèrement positive pour éviter la mise en compression de la lame de torsion, la fréquence de résonance principale correspond à la fréquence propre du système oscillant proprement dit. Dans l'exemple servant de support à la présente description cette fréquence de résonance principale est de l'ordre de 340 Hz.

Les fréquences de résonance secondaires sont égales respectivement à 715 Hz et 945 Hz.

On observe que l'on peut faire varier la fréquence de résonance principale en agissant légèrement sur la vis de réglage pour atteindre une fréquence prédéterminée, par exemple une fréquence de 348 Hz. On atteint alors une contrainte de traction de l'ordre de 300 MPa.

Cette plage de réglage correspond aux valeurs de réglage de la traction allant de 30 MPa à 300 MPa usuellement rencontrées lorsqu'aucune précaution n'est prise pour renforcer la résistance de la lame de torsion 2.

Lorsqu'on augmente la contrainte de traction à une valeur de 800 MPa, la fréquence de résonance principale (Mode 1) évolue très peu et passe alors à une valeur de 362 Hz, alors que les fréquences de résonance secondaires (Mode 2 et Mode 3) se sont décalées respectivement à une valeur de 1730 Hz et de 1830 Hz, soit sensiblement le double des valeurs précédentes.

En augmentant encore la valeur de la contrainte de traction à 1200 MPa, on observe que la fréquence de résonance principale (Mode 1) varie toujours très peu et s'élève à 376 Hz. En revanche, les fréquences de résonance secondaires varient encore fortement, en s'éloignant à nouveau de la fréquence de résonance principale et s'élèvent respectivement à des valeurs de 2340 Hz (Mode 2) et 2320 Hz (Mode 3) ; soit le triple des valeurs de départ.

Et pour une contrainte de 1800 MPa, le mode de résonnance d'ordre 2 s'élève à 3300Hz et le mode de résonnance d'ordre 3 s'élève à 3000Hz, très loin des valeurs de départ.

Il est ainsi possible d'éloigner fortement les fréquences de résonance secondaires (de mode 2 ou 3) de la fréquence de résonance principale et de rendre le résonateur plus stable et moins sensible aux chocs ou aux perturbations extérieures. Pour une même perturbation externe, l'augmentation des fréquences de résonance secondaires s'associe à une diminution quadratique des amplitudes de vibration.

Les valeurs revendiquées dans la présente description sont particulièrement adaptées à un résonateur électromécanique de petite taille. On entend ici par petite taille un résonateur dont les dimensions principales telles que la hauteur, la largeur, la profondeur ou encore une diagonale mesurée entre deux points extrêmes sont inférieures à une vingtaine de millimètres. Moyennant une miniaturisation des composants, il est possible d'atteindre une dimension principale réduite d'un facteur deux et inférieure à 10mm.

Pour ce type de résonateur, la longueur libre totale (2L) totale est inférieure à 10mm, l'épaisseur e de la lame de torsion est inférieure ou égale à 0,2mm et la largeur minimale W est sensiblement inférieure ou égale à 1mm.

Toutefois, les enseignements de la présente invention peuvent s'appliquer mutatis mutandis à des résonateurs de tailles différentes du type décrit ci-dessus.

A titre d'exemple, l'invention peut être transposée au domaine micro électromécanique plus connu sous l'acronyme anglosaxon de MEMS (Micro Electro Mechanical Systems).

### Liste de références

1 Résonateur électromécanique.
2 Lame de torsion.
20 Bras.
21 Zone d'attache de la lame de torsion en forme de T.
22 Zone de raccordement de la partie libre de la lame de torsion avec le bras ou les zones d'attache.
23 Partie libre de la lame de torsion.
3 Cadre.
30 Socle.
31 Montant transversal.
32 Zone flexible déformable.
4 Tige de pré-tension.
40 Vis de réglage.
5 Miroir.
50 Entretoise.
6 Bobines.
7 Aimants.
8 Vis de fixation.
e Epaisseur de la lame de torsion.
R Rayon de raccordement.
S₁ Secteur angulaire de la zone de raccordement adjacent à la partie libre.
S₂ Secteur angulaire de la zone de raccordement adjacent à un bras ou à une zone de raccordement.
R₁ Rayon de la partie de la zone de raccordement située dans le secteur angulaire S₁.
R₂ Rayon de la partie de la zone de raccordement située dans le secteur angulaire S₁.
W Largeur minimale de la lame de torsion.
L Distance libre entre les bras et la zone d'attache.

## Revendications

1. Résonateur électromécanique (1) comprenant une lame de torsion (2) s'étendant selon un axe longitudinal (XX') et fixée par ses deux extrémités sur un cadre (3), ladite lame de torsion (2) comportant un ou plusieurs bras, s'étendant depuis une partie centrale de la lame de torsion (2) selon un axe transversal (YY') et à l'extrémité desquels sont disposés des aimants (7) placés chacun au droit d'une bobine électromagnétique (6) montée sur le cadre (3), de sorte que, lorsque le résonateur (1) est en fonctionnement, la lame de torsion (2) oscille autour de l'axe longitudinal (XX'), ledit cadre comportant une tige de pré-tension (4) pour soumettre une partie libre (23) de la lame de torsion (2) à une contrainte de traction, **caractérisé en ce** la lame de torsion (2) est formée d'un matériau dont la contrainte de rupture est supérieure ou égale à 1200 MPa et préférentiellement supérieure à 2000MPa, et que la tige de pré-tension (4) soumet la partie libre (23) de la lame de torsion (2) à une contrainte de traction comprise entre 800 MPa et ladite contrainte de rupture de la lame de torsion (2).

2. Résonateur électromécanique (1) selon la revendication 1, dans lequel le cadre (3) comporte un socle (30) supportant deux montants transversaux (31) sur lesquels sont fixées les deux extrémités (21) de la lame de torsion (2).

3. Résonateur électromécanique (1) selon la revendication 2, dans lequel la tige de pré-tension (4) est disposée longitudinalement entre les deux montants (31), de sorte que la mise en compression de la tige de pré-tension entraîne la mise en traction de la lame de torsion.

4. Résonateur électromécanique (1) selon la revendication 3, dans lequel la mise en compression de ladite tige de pré-tension (4) est ajustable à l'aide d'une vis de réglage (40).

5. Résonateur électromécanique (1) selon l'une quelconque des revendications précédentes, dans lequel un miroir (5), monté par l'intermédiaire d'au moins une entretoise (50) sur la partie centrale de la lame de torsion (2), ou réalisé par polissage de la partie centrale de ladite lame de torsion (2) s'étend dans un plan formé par les axes longitudinaux (XX') et transversaux (YY').

6. Résonateur électromécanique (1) selon l'une quelconque des revendications 2 à 5, dans lequel les extrémités de la lame (21) de torsion (2) s'étendent transversalement de part et d'autre de l'axe longitudinal (XX') et sont chacune fixées sur les montants (31) du cadre.

7. Résonateur électromécanique (1) selon la revendication 6, dans lequel le rayon de raccordement (R) entre la partie libre (23) de la lame de torsion (2) et un bras ou une zone d'attache (21) de la lame de torsion (2) est constant et supérieur en tous points à une largeur minimale (W) de la lame de torsion (2).

8. Résonateur électromagnétique selon la revendication 6 dans lequel, dans un secteur angulaire de 45° (Si) adjacent à la partie libre (23) de la lame de torsion (2), le rayon de raccordement (R₁) entre la partie libre (23) de la lame de torsion (2) et un bras (20) ou une zone d'attache (21) est en tous points supérieur à une largeur minimale (R₁>W) de la partie libre (23) de la lame de torsion (2).

9. Résonateur électromagnétique selon la revendication 6 dans lequel, dans un secteur angulaire de 45° (Si) adjacent à la partie libre (23) de la lame de torsion (2) le rayon de raccordement (R₁) entre la partie libre (23) de la lame de torsion (2) et un bras (20) ou une zone d'attache (21), est en tous points supérieur à deux fois une largeur minimale (R₁>2W) de la partie libre (23) de la lame de torsion (2).

10. Résonateur électromagnétique selon la revendication 6 dans lequel, dans un secteur angulaire de 45° (Si) adjacent à la partie libre (23) de la lame de torsion (2) le rayon de raccordement (R1) entre la partie libre (23) de la lame de torsion (2) et un bras (20) ou une zone d'attache (21), est en tous points supérieur à trois fois une largeur minimale (R₁>3W) de la partie libre (2) lame de torsion (2).

11. Résonateur électromécanique (1) selon l'une quelconque des revendications précédentes, dans lequel une dimension principale du résonateur (1) est inférieure ou égale à 20 mm et préférablement inférieure à 10 mm.
